# EUROPÄISCHE PATENTSCHRIFT

(11) **EP 1 797 437 B1**
(45) Veröffentlichungstag und Bekanntmachung des Hinweises auf die Patenterteilung: **20.02.2008**
(21) Anmeldenummer: 05797304.2
(22) Anmeldetag: 27.09.2005
(51) Int. Cl.: G01R 1/20, G01R 19/00

(54) **GERÄT ZUM ERMITTELN VON ELEKTRISCHEN GRÖSSEN**
DEVICE FOR DETERMINING ELECTRIC VARIABLES
APPAREIL SERVANT A DETERMINER DES GRANDEURS ELECTRIQUES

(30) Priorität: 30.09.2004 DE 102004049251
(43) Veröffentlichungstag der Anmeldung: 20.06.2007
(73) Patentinhaber: ROBERT BOSCH GMBH, 70442 Stuttgart (DE)
(72) Erfinder: KOELLE, Gerhard, 75446 Wiernsheim (DE); MAZINGUE-DESAILLY, Stephan, 71640 Ludwigsburg (DE); LERICH, Alexander, 71701 Schwieberdingen (DE)
(86) Internationale Anmeldenummer: PCT/EP2005/054839
(87) Internationale Veröffentlichungsnummer: WO 2006/035025

(56) Entgegenhaltungen:
- DE-U1- 20 318 266
- US-B1- 6 218 805

## Beschreibung

### Stand der Technik

Die Erfindung betrifft ein Gerät zum Ermitteln von elektrischen Größen nach der Gattung des unabhängigen Patentanspruchs.

Aus der deutschen Offenlegungsschrift DE 199 61 311 A1 ist ein entsprechendes Gerät bekannt, bei der die elektrische Auswerteeinheit sehr dicht an den elektrischen Hauptleiter gebracht ist. Dadurch wird die Möglichkeit zur Einkupplung von Störsignalen reduziert. Eine Leiterplatte ist mit der Auswerteeinheit ist über die Verbindungsleiter zwischen der Auswerteeinheit und dem Hauptleiter auf diesen gelötet. Um eine gute Dichtheit gegen eindringende Feuchtigkeit zu gewährleisten, ist diese Anordnung mit Kunststoff umspritzt. Bei dieser Ausführung ist nachteilig, dass erstens die Ausdehnungskoeffizienten von Hauptleiter und Leiterplatte sehr unterschiedlich sind und somit bei Temperaturwechseln und somit erzeugten Längenänderungen unerwünschte mechanische Spannungen zwischen Hauptleiter und der Leiterplatte der Auswerteeinheit auftreten können.

Aus der US 6,218,805 B1 ist ein elektrisches Gleichspannungssystem mit einer wiederaufladbaren Batterie und einer Batteriemessklemme bekannt, wobei die Batteriemessklemme einen Sensor und eine Signalverarbeitungseinheit umfasst.

Die DE 203 18 266 U1 offenbart eine Vorrichtung zur Strommessung bestehend aus einem plattenförmigen Widerstand und einer Messelektronik.

### Vorteile der Erfindung

Das erfindungsgemäße Gerät zum Ermitteln von elektrischen Größen mit den Merkmalen des Hauptanspruchs hat den Vorteil, dass der Messabschnitt des Hauptleiters durch das Spritzgussgehäuse einerseits vollständig und unmittelbar abgedichtet und gehalten ist und andererseits die Dichtwirkung unabhängig von Differenzen mechanischer Spannungen zwischen Hauptleiter und Auswerteeinheit ist. Dadurch dass diese mechanischen Spannungsdifferenzen nicht auftreten, ist die Dichtwirkung des Spritzgussgehäuses auch zuverlässig über einen längeren Zeitraum gesichert. Als Nebeneffekt kann mit einer verlängerten Lebensdauer der Auswerteeinheit gerechnet werden, da diese ebenfalls keinen oder fast keinen durch den Hauptleiter erzeugten und erzwungenen mechanischen Spannungen ausgesetzt ist.

Durch die in den Unteransprüchen aufgeführten Maßnahmen sind vorteilhafte Weiterbildungen des Geräts zum Ermitteln von elektrischen Größen nach dem Hauptanspruch möglich. Sind ein oder mehrere Verbindungsleiter zwischen dem Hauptleiter und der Auswerteeinheit angeordnet, und durchdringen diese eine zwischen Hauptleiter und Auswerteeinheit angeordnete Trennwand des Spritzgussgehäuses, so ist gewährleistet, dass bei auf den Hauptleiter vormontierten Verbindungsleitern und nachfolgendem Spritzen des Spritzgussgehäuses vermieden wird, dass größere oder spritzgusstechnisch nicht beherrschbare Fugen entstehen. Die Dichtheit des Geräts insbesondere zum Hauptleiter wird so besonders gut gewährleistet.

Damit der Hauptleiter sicher abgedichtet ist und somit korrosiven Einflüssen nicht ausgesetzt ist, ist vorgesehen dass die Fuge zwischen Trennwand und dem zumindest einen Verbindungsleiter dicht ist. Dies kann bspw. bereits dadurch erzielt werden, dass die Spritzgussmasse um den Verbindungsleiter herum abdichtet.

Alternativ kann eine Abdichtung zwischen der Trennwand und der Auswerteeinheit und somit schließlich auch des Hauptleiters dadurch erzielt werden, indem zwischen der Auswerteeinheit und der Trennwand ein Dichtmittel angeordnet ist.

Es ist vorgesehen, dass die Trennwand den Hauptleiter von einem Raum trennt, in dem die Auswerteeinheit angeordnet ist. Es ergeben sich somit bei diesem Gerät zumindest zwei Räume, die funktional getrennt sind und sich somit gegenseitig sowenig wie möglich beeinflussen. Der erste Raum ist der Raum, der durch den Hauptleiter vollständig ausgefüllt ist, der zweite Raum ist der Raum, in dem die Auswerteeinheit angeordnet ist.

Schließlich ist vorgesehen, dass der Raum in dem die Auswerteeinheit angeordnet ist, durch einen Deckel verschlossen ist.

### Zeichnung

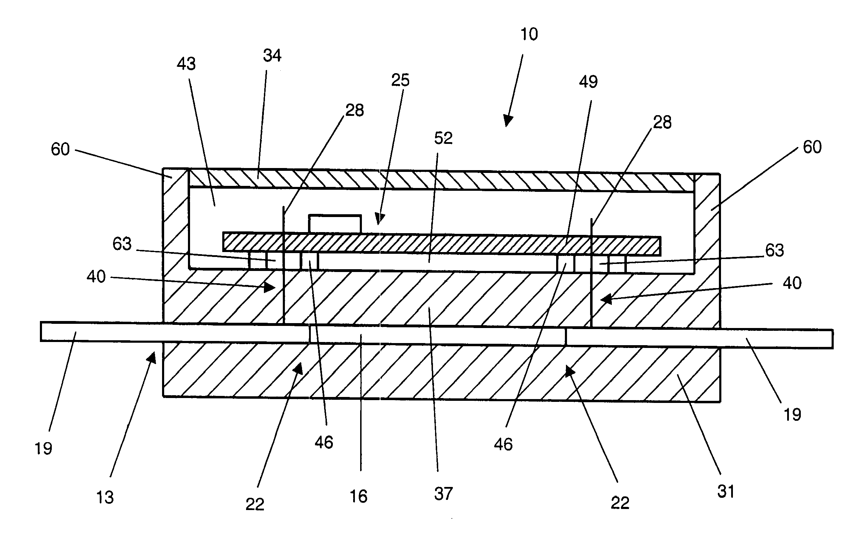

In der Zeichnung ist eine Schnittansicht eines erfindungsgemäßen Gerätes zum Ermitteln von elektrischen Größen dargestellt.

### Beschreibung

In der Figur ist ein Längsschnitt durch das erfindungsgemäße Gerät 10 dargestellt. Das Gerät 10 weist einen elektrischen Hauptleiter 13 auf, der in diesem Beispiel ein ebener Streifen ist. Der elektrische Hauptleiter 13 lässt sich hier in drei Abschnitte unterteilen. Der erste Abschnitt ist der sogenannte Messabschnitt 16, der hier beispielhaft in der Mitte des elektrischen Hauptleiters 13 angeordnet ist. Beiderseits des Messabschnitts 16 sind je ein Anschlussbereich 19 vorhanden. Der Messabschnitt 16 besteht üblicherweise aus einer speziellen Legierung, bspw. Manganin, die für Stromsensoren günstige Eigenschaften aufweist. Die Anschlussbereiche 19 wiederum können bspw. aus Kupfer ausgeführt sein. Die beiden Anschlussbereiche 19 und der Messabschnitt 16 sind durch eine Schweißverbindung an dem jeweiligen Stoß 22 zwischen einem Anschlussbereich 19 und dem Messabschnitt 16 verbunden. Dieser elektrische Hauptleiter 13 ist dazu vorgesehen, einen Laststrom durchzuleiten. Hierzu ist bspw. der linke Anschlussbereich 19 zumindest mittelbar mit einem Pol einer elektrischen Stromversorgungseinrichtung verbunden. Dagegen ist der in der Figur rechte Anschlussbereich 19 mit elektrischen Verbrauchern verbunden. Mit der Durchleitung des Laststroms ändern sich die Eigenschaften des Messabschnitts 16, die durch eine elektrische Auswerteeinheit 25 ermittelt werden. Die elektrische Auswerteeinheit 25 ist hierzu im Beispiel mittels zumindest zweier Verbindungsleiter 28 mit dem Hauptleiter 13 schaltungstechnisch verbunden. Es ist vorgesehen, dass die Verbindungsleiter 28 den Messabschnitt 16 schaltungstechnisch zwischen sich aufnehmen. Es können noch weitere Verbindungsleitungen 28 zwischen dem elektrischen Hauptleiter 13 und der Auswerteeinheit 25 vorgesehen sein, diese sind jedoch hier nicht dargestellt. Ein Gehäuse 31 hält sowohl den elektrischen Hauptleiter 13 als auch die Auswerteeinheit 25 und ist mittels eines Deckels 34 verschlossen.

Zur möglichst dichten Lagerung des Hauptleiters 13 im Gehäuse 31 ist hier vorgesehen, dass der Messabschnitt 16 unmittelbar durch das als Spritzgussgehäuse ausgeführte Gehäuse 31 abgedichtet und gehalten ist.

Es ist somit ein Gerät 10 zum Ermitteln von elektrischen Größen vorgesehen, welches ein Gehäuse 31 und einen elektrischen Hauptleiter 13 hat, wobei dieser Hauptleiter 13 für die Durchleitung eines Laststroms vorgesehen ist. Der Hauptleiter 13 hat einen Messabschnitt 16. Die elektrische Auswerteeinheit 25 ist mit dem elektrischen Hauptleiter 13 leitfähig verbunden. Der Messabschnitt 16 ist unmittelbar durch das als Spritzgussgehäuse ausgeführte Gehäuse 31 abgedichtet und gehalten.

Das Gehäuse 31 hat eine Trennwand 37, die zwischen dem elektrischen Hauptleiter 13 und der Auswerteeinheit 25 angeordnet ist. Die Verbindungsleiter 28 durchdringen die Trennwand 37.

Dadurch, dass die Verbindungsleiter 28 die Trennwand 37 durchdringen, ist an dieser Stelle eine Fuge 40. Damit zwischen einem Raum 43, in dem die Auswerteeinheit 25 untergebracht ist, und dem elektrischen Hauptleiter 13 keine Feuchtigkeit transportiert werden kann, ist vorgesehen, dass a) die Fuge 40 zwischen Trennwand 37 und dem zumindest einen Verbindungsleiter 28 dicht ist, und/oder b) dass die Fuge 40 zwischen Trennwand 37 und dem zumindest einen Verbindungsleiter 28 durch ein Dichtmittel 46 zwischen Trennwand 37 und Auswerteeinheit 25 abgedichtet ist. Dies kann bspw. dadurch realisiert sein, dass die Auswerteeinheit 25 einerseits eine Leiterplatte 49 hat und zwischen der Leiterplatte 49 und der Trennwand 37 ein Spalt 52 ist. So die Verbindungsleiter 28 durch eine mechanisch dichte Verbindung mit der Leiterplatte 49 verbunden sind, kann durch ein Dichtmittel 46, welches um die Verbindungsleiter 28 herum angeordnet ist, ein mechanisch dichter Spalt 40 erreicht werden.

Das Gehäuse 31 ist im Beispiel derart gestaltet, dass sich auf der vom Hauptleiter 13 abgewandten Seite der Trennwand 37 Wände 60 erstrecken. Diese Wände 60 bilden den Raum 43 und weisen in die vom Hauptleiter 13 abgewandte Richtung. Der durch die Wände 60 ringsum geschlossene Raum 43 ist durch den Deckel 34 geschlossen.

Als Material für das Gehäuse 31 und auch den Deckel 34 ist ein Kunststoff vorgesehen. Die Verbindungsleiter 28 erstrecken sich senkrecht vom elektrischen Hauptleiter 13 und können auf dem Hauptleiter 13 verlötet oder mit diesem verschweißt sein. Alternativ ist es auch möglich, die Verbindungsleiter 28 in entsprechende Bohrungen des Hauptleiters 13 einzupressen.

Es ist nicht nur möglich, die Verbindungsleiter 28 aus einzelnen Drahtverbindungen darzustellen. Vielmehr ist es z.B. auch möglich, durch Umformen der Anschlussbereich 19 elektrische Verbindungen zur Auswerteeinheit 25 zu ermöglichen. Es könnte auch durch ein entsprechendes Stanz- oder Stanzbiegeteil eine Verbindung zur Auswerteeinheit 25 ermöglicht sein.

Die Auswerteeinheit 25 sitzt auf mehreren Podesten 63 auf, die bspw. einstückig mit der Trennwand 37 ausgeführt sind. Die Podeste 63 umgeben dabei auch die Verbindungsleiter oder zumindest einen Teil der Verbindungsleiter 28.

Bei geeigneter Ausführung der Verbindungsleiter 28 können diese nicht nur die elektrische Verbindung zwischen Hauptleiter 13 und Auswerteeinheit 25 darstellen, sondern gleichzeitig auch die mechanische Befestigung der Auswerteeinheit 25 im Gehäuse 31. Die mechanische Befestigung der Auswerteeinheit 25 kann aber auch nur durch die Verbindungsleiter 28 unterstützt sein, da andere Befestigungsmittel vorhanden sein können.

Zur Auswertung der elektrischen Spannung im Messabschnitt 16 ist vorgesehen, dass zumindest zwei der Verbindungsleiter 28 hierzu verwendet werden. Hierzu ist ein Verbindungsleiter 28 im Bereich eines jeden Stoßes 22 vorzusehen. Der Verbindungsleiter 28 braucht hierzu nicht zwangsläufig im Anschlussbereich 19 angeordnet zu sein, vielmehr kann ein solcher Verbindungsleiter 28 auch auf dem Messabschnitt 16 positioniert sein.

Die Verbindung der Verbindungsleiter 28 zur Auswerteeinheit 25 hin kann auf verschiedene Art und Weise ausgeführt sein. So können die Verbindungsleiter 28 bspw. in entsprechende Aussparungen in der Leiterplatte 49 eingepresst oder eingelötet sein. Alternativ können die Verbindungsleiter 28 auch auf entsprechenden, hier nicht dargestellten Kontaktflächen auf der Leiterplatte aufgelötet oder elektrisch leitfähig durch Kleben verbunden sein.

## Patentansprüche

1. Gerät zum Ermitteln von elektrischen Größen, mit einem Gehäuse (31) und mit einem elektrischen Hauptleiter (13), der für die Durchleitung eines Laststroms vorgesehen ist und der einen Messabschnitt (16) hat, mit einer elektrischen Auswerteeinheit (25), die mit dem elektrischen Hauptleiter (13) elektrisch leitfähig verbunden ist, wobei der Messabschnitt (16) unmittelbar durch das als Spritzgussgehäuse ausgeführte Gehäuse (31) abgedichtet und gehalten ist, wobei zumindest zwei Verbindungsleiter (28) den Hauptleiter (13) mit der Auswerteeinheit (25) elektrisch verbinden, **dadurch gekennzeichnet, dass** die zumindest zwei Verbindungsleiter (28) eine zwischen Hauptleiter (13) und Auswerteeinheit (25) angeordnete Trennwand (37) des Spritzgussgehäuses (31) durchdringen.

2. Gerät nach Anspruch 1, **dadurch gekennzeichnet, dass** eine Fuge (40) zwischen Trennwand (37) und den zumindest zwei Verbindungsleitern (28) dicht ist.

3. Gerät nach Anspruch 1 oder 2, **dadurch gekennzeichnet, dass** eine Fuge (40) zwischen Trennwand (37) und dem zumindest einen Verbindungsleiter (28) durch ein Dichtmittel (46) zwischen Trennwand (37) und Auswerteeinheit (25) abgedichtet ist.

4. Gerät nach einem der Ansprüche 1 bis 3, **dadurch gekennzeichnet, dass** die Trennwand (37) den Hauptleiter (13) von einem Raum (43) trennt, in dem die Auswerteeinheit (25) angeordnet ist.

5. Gerät nach Anspruch 4, **dadurch gekennzeichnet, dass** der Raum (43) durch einen Deckel (34) geschlossen ist.

## Claims

1. Device for determining electric variables, said device having a housing (31) and having an electrical main conductor (13), which is intended to conduct a load current and has a measurement section (16), and having an electrical evaluation unit (25) which is electrically conductively connected to the electrical main conductor (13), the measurement section (16) being directly sealed and held by the housing (31) which is in the form of an injection-moulded housing, at least two connecting conductors (28) electrically connecting the main conductor (13) to the evaluation unit (25), **characterized in that** the at least two connecting conductors (28) penetrate a dividing wall (37) of the injection-moulded housing (31), said dividing wall being arranged between the main conductor (13) and the evaluation unit (25).

2. Device according to Claim 1, **characterized in that** a join (40) between the dividing wall (37) and the at least two connecting conductors (28) is tight.

3. Device according to Claim 1 or 2, **characterized in that** a join (40) between the dividing wall (37) and the at least one connecting conductor (28) is sealed by a sealing means (46) between the dividing wall (37) and the evaluation unit (25).

4. Device according to one of Claims 1 to 3, **characterized in that** the dividing wall (37) separates the main conductor (13) from a space (43) in which the evaluation unit (25) is arranged.

5. Device according to Claim 4, **characterized in that** the space (43) is closed by a cover (34).

## Revendications

1. Appareil pour déterminer des grandeurs électriques comprenant :
- un boîtier (31) et un conducteur électrique principal (13) pour le passage d'un courant de charge et ayant un segment de mesure (16),
- une unité d'exploitation électrique (25) reliée électriquement au conducteur électrique principal (13),
- le segment de mesure (16) étant rendu étanche et tenu par le boîtier (31) réalisé comme boîtier injecté,
- au moins deux conducteurs de liaison (28) reliant électriquement le conducteur principal (13) à l'unité d'exploitation (25),
**caractérisé en ce qu'**
au moins les deux conducteurs de liaison (28) traversent une cloison (37) séparant le conducteur principal (13) et l'unité d'exploitation (25) dans le boîtier injecté (31).

2. Appareil selon la revendication 1,
**caractérisé en ce que**
le joint (40) entre la cloison (37) et au moins les deux conducteurs de liaison (28) est étanche.

3. Appareil selon la revendication 1 ou 2,
**caractérisé en ce que**
le joint (40) entre la cloison (37) et au moins l'un des conducteurs de liaison (28) est rendu étanche par un moyen d'étanchéité (46) entre la cloison (37) et l'unité d'exploitation (25).

4. Appareil selon l'une des revendications 1 à 3,
**caractérisé en ce que**
la cloison (37) sépare le conducteur principal (13) d'une chambre (43) dans laquelle se trouve l'unité d'exploitation (25).

5. Appareil selon la revendication 4,
**caractérisé en ce que**
le volume (43) est fermé par un couvercle (34).
